# EUROPEAN PATENT APPLICATION

(11) **EP 4 307 849 A1**
(43) Date of publication of application: **17.01.2024**
(21) Application number: 23184960.5
(22) Date of filing: 12.07.2023
(51) Int. Cl.: H05K 7/20, B60L 53/22

(54) **IN-VEHICLE ELECTRICAL INSTRUMENT**

(30) Priority: 14.07.2022 JP 2022113341
(71) Applicant: TOYOTA JIDOSHA KABUSHIKI KAISHA, Toyota-shi, Aichi-ken, 471 8571 (JP)
(72) Inventor: TERAOKA, Yuuki, TOYOTA-SHI, AICHI-KEN, 471-8571 (JP); YABUUCHI, Takeyuki, TOYOTA-SHI, AICHI-KEN, 471-8571 (JP); NISHIDE, Tatsuya, TOYOTA-SHI, AICHI-KEN, 471-8571 (JP)
(74) Representative: Cabinet Beau de Loménie

(57) **Abstract**

An in-vehicle electrical instrument (10) includes a substrate (S) on which at least one electronic component (P) is mounted; a case (20) configured to accommodate the substrate; a substrate support section (210) that is naturally or forcibly cooled and disposed in the case to support the substrate; an opposing section (220) that is disposed in the case to be opposed to the substrate support section at an interval; and a pressing mechanism (30) that is supported by the opposing section and presses either the electronic component of the substrate supported by the substrate support section or the substrate against the substrate support section. The in-vehicle electrical instrument satisfactorily cools the electronic component of the substrate accommodated in the case while ensuring the mountability of the in-vehicle electric device.

## Description

### Technical Field

The present disclosure relates to an in-vehicle electrical instrument that includes a substrate on which at least one electronic component is mounted and a case configured to accommodate the substrate.

### Background

A conventionally known cooling structure cools a plurality of plate-shaped heat-generating devices, including a battery, a DC voltage converter, relays and the like with a cooling fluid (as described in, for example, Japanese Patent Application Laid-Open No. 2006-216303). The cooling structure includes a heat exchange member and a spring member. The heat exchange member alternately forms flat device housing spaces in which the heat generating device is accommodated and flat cooling passages in a plate thickness direction of the heat generating devices. The spring member generates a spring force in a direction to press the heat generating device and the heat exchange member against each other. The cooling structure enables the cooling fluid passing through the cooling passages to remove heat from both sides of each heat generating device through the heat exchange members.

### Summary

In an in-vehicle electrical instrument that includes a substrate on which electronic components are mounted and a case that accommodates the substrate, the heat from the electronic components may be released to the case by pressing the electronic components or the substrate against the surface of the case with a leaf spring (spring member). However, in order to press the electronic component or the substrate against the case by the leaf spring, a boss portion or the like for supporting the leaf spring must be formed in the case so as to be located around the objective electronic component. The addition of the boss portion or the like increases a size of the case and deteriorates mountability of the in-vehicle electrical instrument.

A main object of the present disclosure is to satisfactorily cool the electronic component of the substrate accommodated in the case of the in-vehicle electric instrument while ensuring the mountability of the in-vehicle electric device.

An in-vehicle electrical instrument of the present disclosure is mounted on a vehicle and includes a substrate on which at least one electronic component is mounted and a case configured to accommodate the substrate. The in-vehicle electrical instrument includes: a substrate support section that is naturally or forcibly cooled and disposed in the case to support the substrate; an opposing section that is disposed in the case to be opposed to the substrate support section at an interval; and a pressing mechanism that is supported by the opposing section and presses either the electronic component of the substrate supported by the substrate support section or the substrate against the substrate support section.

The in-vehicle electrical instrument of the present disclosure satisfactorily cools the electronic component of the substrate accommodated in the case while suppressing an increase in a size of the case, that is, an area of the substrate support section and ensuring mountability of the in-vehicle electric device.

### Brief Description of Drawings

Fig. 1 is a schematic configuration diagram illustrating a vehicle including the in-vehicle electrical instrument according to the present disclosure;
Fig. 2 is a partial cross-sectional view illustrating the in-vehicle electrical instrument according to the present disclosure;
Fig. 3 is an enlarged view illustrating a main part of the in-vehicle electrical instrument according to the present disclosure; and
Fig. 4 is an enlarged view illustrating a main part of another in-vehicle electrical instrument according to the present disclosure.

### Description of Embodiments

The following describes some embodiments of the disclosure with reference to drawings.

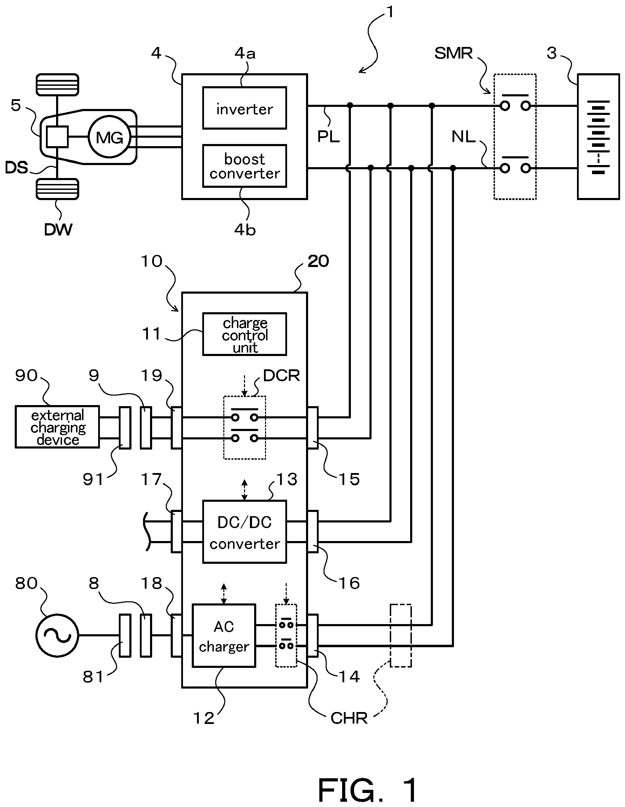

Fig. 1 is a schematic configuration diagram illustrating a battery electric vehicle 1 as an electric vehicle including an electric power supply unit (hereinafter referred to as "ESU") 10, which is an in-vehicle electrical instrument of the present disclosure. In addition to the ESU 10, the battery electric vehicle 1 shown in Fig. 1 includes a battery (high-voltage battery) 3, a system main relay (SMR), a power control unit (hereinafter referred to as "PCU") 4, and a motor generator MG. In this embodiment, the battery electric vehicle 1 is a front-wheel drive vehicle. However, the battery electric vehicle 1 may also be a rear-wheel drive vehicle or a four-wheel drive vehicle.

The battery 3 includes a plurality of battery modules (battery stacks) connected in series and a battery case that accommodates the battery modules . The battery 3 is mounted under a floor (below a floor panel) of the battery electric vehicle 1 near rear seats, for example. Each battery module of the battery 3 includes a plurality of battery cells (not shown) connected in series or parallel. Each battery cell is, for example, a lithium-ion secondary battery or a nickel-metal hydride secondary battery and the like. A positive terminal of battery 3 is connected to a positive pole side power line PL via a positive relay of the system main relay SMR. A negative terminal of battery 3 is connected to a negative pole side power line NL via a negative relay of the system main relay SMR.

The PCU 4 is connected to the battery 3 via the positive pole side power line PL, the negative pole side power line NL and the system main relay SMR. The PCU 4 includes an inverter (drive circuit) 4a, a boost converter 4b, capacitors configured to be charged and discharged (not shown) and the like. The inverter 4a drives the motor generator MG. The boost converter 4b is configured to boost electric power from the battery 3 and to step down a voltage from the motor generator MG side.

The motor generator MG is a synchronous generator motor (three-phase AC motor). A rotor of the motor generator MG is connected to drive shafts DS, which is connected to drive wheels DW, via a power transmission mechanism including a reduction gear and a differential gear. The motor generator MG is driven by electric power from the PCU 4 (battery 3), and outputs drive torque (driving force) to the drive shaft DS. Further, the motor generator MG outputs regenerative braking torque to the drive shaft DS when braking the battery electric vehicle 1. In this embodiment, the motor generator MG, the reduction gear and the differential gear are accommodated in a transaxle case, and form transaxle 5 together with the transaxle case.

The ESU 10 is mounted in the battery electric vehicle 1 to enable the battery 3 to be charged by electric power from an AC power source 80 such as a household power source or an external charging device (DC power source) 90 such as a quick charger installed at a gas station. The ESU 10 is mounted in a front compartment of the battery electric vehicle 1 together with the transaxle 5. In this embodiment, the ESU 10 is fastened (fixed) to a vehicle body via a plurality of bolts such that it is located above the transaxle 5, behind a radiator (not shown), and in front of a dash panel (bulkhead), and in front of the dash panel (bulkhead) not shown in the figure.

As shown in Fig. 1, the ESU 10 includes a charging control unit (charge ECU) 11, an AC charger 12, charging relays CHR and DCR, a DC/DC converter 13, a filter F, a junction box JB, a busbar unit (not shown), and a case 20 that accommodates these devices. The charge control unit 11 is a microcomputer that includes a CPU, ROM, RAM and the like, which are not shown in the figure. The charge control unit 11 controls the AC charger 12 and the DC/DC converter 13 and also controls the charging relays CHR and DCR so as to be opened and closed.

The AC charger 12 includes an AC/DC converter that converts AC power to DC power and a DC/DC converter that boosts the DC power output from the AC/DC converter (not shown) and the like. The AC/DC converter of the AC charger 12 is connected to the outlet plug 8. The outlet plug 8 is configured to be coupled with an outlet 81 of the AC power supply 80 via a connector 18 of the case 20 and cables. Further, the DC/DC converter of the AC charger 12 is connected to the positive pole side power line PL and the negative pole side power line NL between the system main relay SMR and the PCU 4 via the charging relay CHR, a connector 14 of case 20 and power lines . The AC charger 12 is operated under a state where the outlet plug 8 is coupled with the outlet 81 and the system main relay SMR and the charging relay CHR are closed. As a result, the battery 3 is charged with the electric power (AC power) from the AC power source 80.

The charging relay DCR is connected to the positive pole side power line PL and the negative pole side power line NL between the system main relay SMR and the PCU 4 via a connector 15 of case 20 and power lines. The charging relay DCR is also connected to a power receiving connector 9 via a connector 19 of the case 20 and cables. The power receiving connector 9 is configured to be coupled with a power transmitting connector 91 of the external charging device 90 and installed on a charging lid (not shown) of the battery electric vehicle 1. The external charging device 90 is operated in a state where the power receiving connector 9 is coupled with the power transmitting connector 91 and the system main relay SMR and the charging relay DCR are closed. As a result, the battery 3 is charged with the electric power (DC power) from the external charging device 90.

The DC/DC converter 13 is connected to the positive pole side power line PL and the negative pole side power line NL between the system main relay SMR and the PCU 4 via a connector 16 of case 20 and power lines. An output terminal of the DC/DC converter 13 is connected to an auxiliary battery (low-voltage battery, not shown) and various auxiliary equipment via a connector 17 of the case 20 and power lines. The DC/DC converter 13 steps down the electric power from the positive pole side power line PL and the negative pole side power line NL and supplies the electric power to the auxiliary battery and various auxiliary equipment.

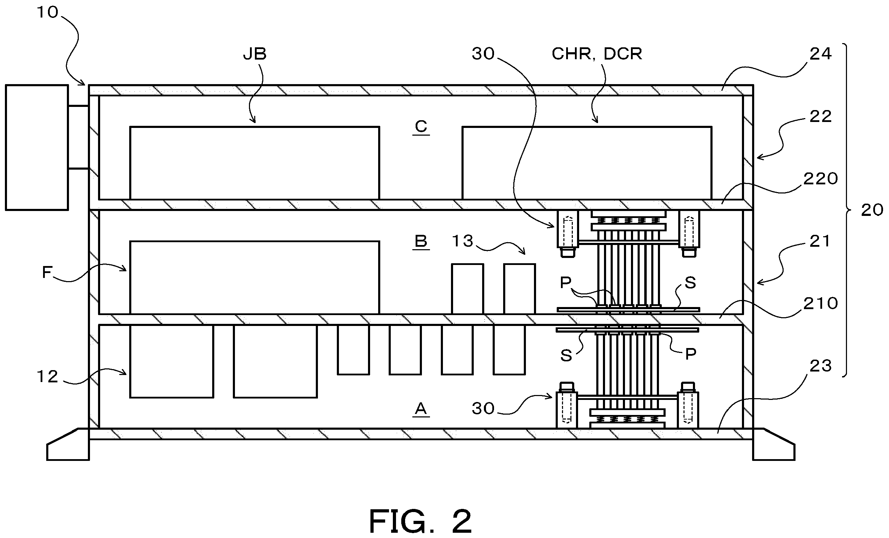

Fig. 2 is a partial cross-sectional view of the ESU 10. As shown in the figure, the case 20 of the ESU 10 includes a square cylindrical lower case 21, a bottomed square cylindrical upper case 22, a lower cover 23, and an upper cover 24. In this embodiment, the lower case 21 and upper case 22 are cast products formed from aluminum alloy or the like. A floor (floor plate portion) 210 is formed in a center of the lower case 21 in a height direction so as to be orthogonal to the height direction. Further, the lower cover 23 and the upper cover 24 are formed of steel plates or the like.

The upper case 22 is connected (fixed) to an upper end of the lower case 21 via a plurality of bolts (not shown). The lower cover 23 is connected (fixed) to a lower end of the lower case 21 via a plurality of bolts (not shown) and forms a bottom (bottom plate portion) of the case 20 (lower case 21) . The upper cover 24 is connected (fixed) to an upper end of the upper case 22 via a plurality of bolts (not shown) and forms a ceiling (top plate portion) of the case 20 (upper case 22) . The floor 210 of the lower case 21 is opposed to the lower cover 23 at an interval in a vertical direction and is opposed to a bottom 220 of the upper case 22, which serves as a floor of the case 20, at an interval in the vertical direction. Further, the bottom 220 of the upper case 22 is opposed to the upper cover 24 at an interval in the vertical direction.

In this embodiment, the AC charger 12 and the like are disposed in a space A defined between the floor 210 of the lower case 21 and the lower cover 23, for example. The DC/DC converter 13, the filter F and the like are disposed in a space B defined between the floor 210 of the lower case 21 and the bottom 220 of the upper case 22, for example. The charging control unit 11 (omitted in Fig. 2), the charging relay CHR, the charging relay DCR, the junction box JB and the like are disposed in a space C defined between the bottom 220 of the upper case 22 and the upper cover 24, for example. The charging relay CHR may be disposed outside the case 20, as shown by a two-dot chain line in Fig. 1.

Refrigerant passages (not shown are formed in the floor 210 of the case 20, and a cooling medium is circulated and supplied to the refrigerant passages by a refrigerant pump or the like (not shown) . This allows the lower case 21 (floor 210), the upper case 22 (bottom 220), the lower cover 23 and the upper cover 24 are forcibly cooled by the cooling medium flowing in the refrigerant passages of the floor 210. When the battery electric vehicle 1 is driven, the lower cover 23, the upper cover 24 and side panels of the case 20 are naturally cooled by driving wind or the like that flows into a front compartment of the battery electric vehicle 1.

Here, the AC charger 12 and the DC/DC converter 13 of the ECU 10 respectively includes a substrate S on which a plurality of electronic components P such as semiconductor devices (for example, FETs) is mounted. These electronic components P generate heat as the AC charger 12 and the DC/DC converter 13 operate. Thus, when charging the battery 3 with the electric power from the external AC power source 80 or the external charging device 90, the electronic components P of each substrate S are required to be cooled. Based on this, the substrate S of the AC charger 12 is supported by the floor 210 of the lower case 21, which is forced cooled, in order to release heat from each electronic component P. Further, the substrate S of the DC/DC converter 13 is also supported by the floor 210 of the lower case 21, which is forced cooled, in order to release the heat from each electronic component P. Furthermore, a plurality of openings is formed in each substrate S such that the electronic components P are exposed (protrude) on both a front surface side and a back surface side. Each electronic component P is mounted in the corresponding opening of the substrate S such that it protrudes on both the front surface side and the back surface side of the substrate S.

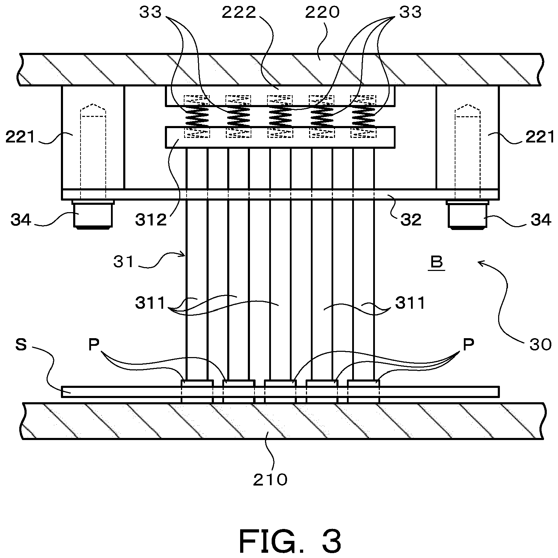

In addition, the ESU 10 includes a plurality (for example, two in this embodiment) of pressing mechanisms 30. One pressing mechanism 30 presses the electronic components P mounted on the substrate S of the AC charger 12 against the floor 210 of the lower case 21 as a substrate support section. The other pressing mechanism 30 presses the electronic components P on the substrate S of the DC/DC converter 13 against the floor portion 210 of the lower case 21 as the substrate support section. The pressing mechanism 30 for the AC charger 12 is supported by the lower cover 23 as an opposing section that is opposed to the floor 210 of the lower case 21. The pressing mechanism 30 for the DC/DC converter 13 is supported by the bottom 220 of the upper case 22 as the opposing section that is opposed to the floor 210 of the lower case 21. In this embodiment, the pressing mechanism 30 for the AC charger 12 and the pressing mechanism 30 for the DC/DC converter 13 have a common configuration. The configuration of the pressing mechanism will be described in detail below using that for the DC/DC converter 13 as an example with reference to Fig. 3.

As shown in Fig. 3, the pressing mechanism 30 includes a pressing member 31, a guide member 32, and a plurality of coil springs (elastic bodies) 33. The pressing member 31 includes a plurality of contact members 311 and a support member 312. Each of the contact members 311 of the pressing member 31 is a round or square bar made of metal or resin, for example. The support member 312 of the pressing member 31 is made of metal or resin, for example. The support member 312 supports the contacting members 311 at intervals such that a tip surface (a lower end surface in Fig. 3) of each contacting member 311 contacts the corresponding electronic component P of the substrate S supported by the floor 210. The contact members 311 and the support member 312 may be formed in one piece. The contact members 311, which are separate from the support member 312, may be fixed to the support members 312.

The guide member 32 is a plate made of metal or resin, for example, and has a plurality of holes formed at intervals. The guide member 32 is fixed to a plurality (for example, two in this embodiment) of boss portions 221 of the upper case 22 by a plurality (for example, two in this embodiment) of bolts 34. Each of the boss sections 221 is extended from the bottom 220 of the upper case 22 toward the floor 210 of the lower case 21. Each of the contact members 311 of the pressing member 31 is slidably inserted into the corresponding hole of the guide member 32 such that the support member 312 is located between the guide member 32 and the bottom 220 of the upper case 22. The guide member 32 of the pressing mechanism 30 for the AC charger 12 is fixed to a plurality of boss portions extending from the lower cover 23 toward the floor 210 by the bolts 34.

The coil springs 33 have the same specifications as each other. Each of the coil springs 33 is supported by an elastic body support portion 222 formed on the bottom 220 of the upper case 22. Also, each of the coil springs 33 is connected to the support member 312 of the pressing member 31. In this embodiment, a plurality of recesses is formed in the elastic support portion 222 of the bottom 220. Each of the recesses of the elastic body support portion 222 is opened toward the floor 210 (lower side in Fig. 3) of the lower case 21 and is opposed to a corresponding end portion (upper end portion in Fig. 3) of the contact member 311 of the pressing member 31. A plurality of recesses is formed in the support member 312 of the pressing member 31. Each of the recesses of the support member 312 is opened toward the bottom 220 (upper side in Fig. 3) of the upper case 22 and is opposed to the corresponding end portion (upper end portion in Fig. 3) of the contact member 311 of the pressing member 31. One end (upper end in Fig. 3) of each coil spring 33 is fitted into the corresponding recess of the elastic support portion 222. The other end (lower end in Fig. 3) of each coil spring 33 is fitted into the corresponding recess of the support member 312 of the pressing member 31. That is, each coil spring 33 is arranged between the elastic body support portion 222 of the bottom 220 and the support member 312 of the pressing member 31 to be opposed the end portion of the corresponding contact member 311 on a side of the bottom 220.

Thus, the pressing members 31, or the contacting members 311, are slidably supported by the bottom 220 of the upper case 22 via the guide member 32 so as to contact the corresponding electronic component P. When each of the coil springs 33 is in the natural state, a distance (shortest distance) from a surface (lower surface in Fig. 3) of the elastic body support portion 222 (bottom portion 220) on a side of the floor 210 to a tip surface (lower end surface in Fig. 3) of each contact member 311 is longer than a distance (shortest distance) from the surface of the elastic body support portion 222 on the side of the floor portion 210 to each electronic component P of the substrate S supported by the floor 210. Each coil spring 33 of the pressing mechanism 30 for the AC charger 12 is supported by an elastic body support portion formed on the lower cover 23 and is connected to the support member 312 of the pressing member 31.

When manufacturing the above described ESU 10, the AC charger 12 is assembled to the lower cover 23 such that the pressing mechanism 30 for the AC charger 1 2 is located on a side of the space A. The components of the AC charger 12 including the substrate S, and other elements are assembled to the floor 210 (lower surface in Fig. 2) of the lower case 21 such that they are located on a side of the space A. The components of the DC/DC converter 13 including the substrate S, the filter F and the like are assembled on the floor 210 (upper surface in Fig. 2) of the lower case 21 such that they are located on a side of the space B. The charge control unit 11, the charge relay CHR, the charge relay DCR, the junction box JB and the like are assembled in the upper case 22 (on the bottom 220) . The pressing mechanism 30 for the DC/DC converter 13 is assembled to the bottom 220 of the upper case 22 (bottom surface in Fig. 2) such that it is located on the side of the space B.

When the lower cover 23 is fixed to the lower case 21, the pressing member 31 (each contacting member 311) of the pressing mechanism 30 for the AC charger 12 contacts the corresponding electronic component P of the substrate S supported by the floor 210 of the lower case 21. Thus, each of the coil springs 33 is pressed by the pressing member 31 and compressed between the support member 312 and the lower cover 23 (elastic body support not shown in the figure), such that the pressing member 31 is biased to the side of the floor 210 by each of the coil springs 33. Accordingly, each electronic component P of the substrate S supported by the floor 210 is pushed against the floor 210 by the corresponding contact member 311 of the pressing member 31.

Further, when the upper case 22 is fixed to the lower case 21, the pressing member 31 (each contacting member 311) of the pressing mechanism 30 for the DC/DC converter 13 contacts the corresponding electronic component P of the substrate S supported by the floor 210 of the lower case 21. Thus, each of the coil spring 33 is pressed by the pressing member 31 and compressed between the support members 312 and the bottom portion 220 (elastic body support portion 222), such that the pressing member 31 is biased to the side of the floor 210 by each of the coil springs 33. Accordingly, each electronic component P of the substrate S supported by the floor 210 is pushed against the floor 210 by the corresponding contact member 311 of the pressing member 31.

As a result, in the battery electric vehicle 1, when charging the battery 3 by the electric power from either the external AC power source 80 or the external charging device 90, the heat from each electronic component P mounted on the substrate S of the AC charger 12 is released to the floor 210 of the case 20 which is forcibly cooled (or in some cases, naturally cooled) . Further, a part of the heat from each electronic component P mounted on the substrate S of the AC charger 12 is released through the pressing member 31 and each of the coil springs 33 to the lower cover 23 which is naturally or forcibly cooled. In addition, when charging the battery 3 with the power from either the external AC power source 80 or the external charging device 90, the heat from each electronic component P mounted on the substrate S of the DC/DC converter 13 is released to the floor 210 of the case 20 which is forcibly cooled (or in some cases, naturally cooled) . Further, a part of the heat from each electronic component P mounted on the substrate S of the DC/DC converter 13 is released through the pressing member 31 and each of the coil springs 33 to the bottom 220 of the upper case 22 which is naturally or forcibly cooled.

In the ESU 10, each pressing mechanism 30 is supported by either the bottom (opposing section) 220 of the upper case 22 opposed to the floor 210 that supports the substrate S or the lower cover (opposing section) 23 opposed to the floor 210. Thus, it is not necessary to provide the floor 210 with a structure such as a boss or the like which support a plate spring for pressing the electronic component P or the substrate S against the floor 210 so as to be located around the objective electronic component P. This enables the electronic components P of the substrate S accommodated in the case 20 to be satisfactorily cooled when charging battery 3 with the electric power from either the AC power source 80 or the external charging device 90 while suppressing an increase in a size of the case 20, that is, an area of the floor (substrate support section) 210 and ensuring mountability of the ESU 10.

The pressing mechanism 30 includes the pressing member 31 and the coil springs 33. The pressing member 31 is disposed between the floor 210 and the bottom 220 of the upper case 22 or between the floor 210 and the lower cover 23 to contact to the electronic components P of the substrate S supported by the floor 210. The coil springs 33 are disposed between the bottom 220 or the lower cover 23 and the pressing member 31 to bias the pressing member 31 toward the floor 210. This enables the pressing member 31 biased by the coil springs 33 to press the electronic components P against the floor 210, such that the heat from the electronic component P is released to the floor 210 that is forcibly (or naturally) cooled, while reducing an increase in an axial length (size) of the coil spring 33. In addition, the pressing mechanism 30 allows the heat from the electronic component P to be released through the pressing member 31 and the coil springs 33 to either the bottom 220 of the upper case 22 or the lower cover 23.

Further, the pressing mechanism 30 includes the guide member 32 that is supported by either the bottom 220 of the upper case 22 or the lower cover 23 and slidably supports the pressing member 31 so as to contact to the electronic components P. This suppresses the pressing member 31 from falling out of the case 20 (the upper case 22 or the lower cover 23) during manufacturing or disassembly of the ESU 10 and also makes each contact member 311 of the pressing member 31 precisely contact with the corresponding electronic component P.

In the ESU 10, each of the electronic components P is mounted on the substrate S so as to be exposed from the substrate S toward both the front surface side (the side of bottom 220 or the lower cover 23) and the back surface side (the side of the floor 210) . This allows the electronic component P to be in close contact with the floor 210 by the pressing mechanism 30, thereby enabling satisfactorily cooling of the electronic components P when charging battery 3 with the electric power from either the AC power source 80 or the external charging device 90.

In the ESU 10, the plurality of the electronic components P is mounted on the substrate S of the Ac charger 12 and the substrate S of the DC/DC converter 13. The pressing member 31 of each pressing mechanism 30 includes the plurality of contact members 311 respectively configured to contact to the corresponding electronic component P of the substrate S supported by the floor 210. The pressing mechanism 30 includes the support member 312 that supports the plurality of contact members 311 at intervals so as to contact to the corresponding electronic component P. The coil springs 33 of the each pressing mechanism 30 are disposed between the floor 210 and the bottom 220 or between the floor 210 and the lower cover 23. This enables satisfactorily cooling of the electronic components P of the substrate S accommodated in the case 20 while suppressing the increase in the size of the case 20 and ensuring the mountability of the ECU 10.

Each of the coil springs 33 of the pressing mechanism 30 is disposed between the bottom 220 or the lower cover 23 and between the floor 210 and the support member 312 of the pressing member 31 so as to be opposed to the end portion of the corresponding contact member 311 on the side of the bottom 220 or the lower cover 23. This enables biasing force from each of the coil springs 33 to be transmitted stably and efficiently to each contact member 311.

Further, the pressing mechanism 30 includes the plurality of the coil springs 33 as the elastic body that biases the pressing member 31. This reduces an effect of variations in the distance between the bottom 220 or the lower cover 23 and each of the electronic components P on a load applied from each coil spring 33 to the electronic components P via the pressing member 31.

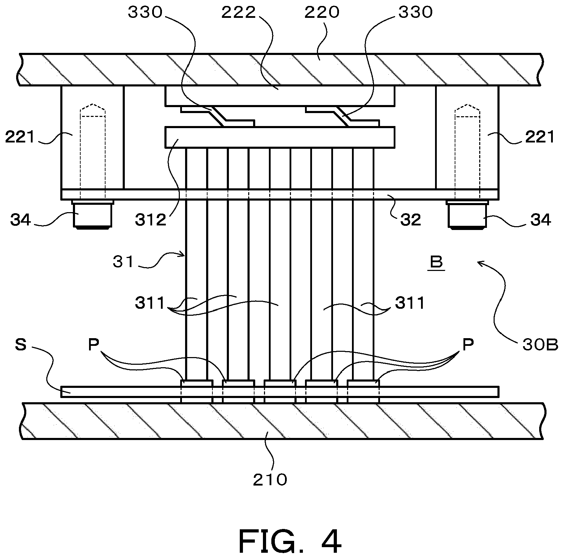

The elastic body that biases the pressing member 31 is not limited to the coil spring 33. That is, as in a pressing mechanism 30B shown in Fig. 4, the plurality of coil springs 33 may be replaced by a plurality of leaf springs 330. The pressing mechanism 30B reduces an effect of variations in the distance between the floor 210 or the bottom 220 and each of the electronic components P on a load applied from each leaf spring 330 to the electronic components P via the pressing member 31. The pressing mechanisms 30, 30B may include single coil spring 33 or single leaf spring 330 as the elastic body that biases the pressing member 31. The coil spring 33 or the leaf spring 330 may be integrally formed with the elastic body support portion 222 and the like or the support member 312. The support member 312 may be omitted from the pressing mechanisms 30, 30B. The coil spring 33 or the leaf spring 330 may be fixed or integrated with the end of the pressing member 31.

In the ESU 10, the pressing mechanism 30 for the AC charger 12 is supported by the lower cover 23 and the pressing mechanism 30 for the DC/DC converter 13 is supported by the bottom 220 of the upper case 22. However, the configuration of the ESU 10 is not limited to this. That is, when the substrate S of the AC charger 12 is supported by the lower cover 23, the pressing mechanisms 30, 30B for the AC charger 12 may be supported by the floor 210 of the lower case 21. When the substrate S of the DC/DC converter 13 is supported by the bottom 220 of the upper case 22, the pressing mechanisms 30, 30 B may be supported by the floor 210 of the lower case 21. When the substrate S is supported by the bottom portion 220 (substrate support section) of the upper case 22 so as to be located within the space C, the pressing mechanisms 30, 30B may be supported by the upper cover (opposing section) 24, which serves as the ceiling of the case 20. When the substrate S is supported by the upper cover (substrate support section) 24 so as to be located within the space C, the pressing mechanisms 30, 30 30B may be supported by the bottom (opposing section) 220 of the upper case 22, which serves as the floor of the case 20.

In ESU 10, the floor 210 and the bottom 220 may be omitted from the case 20. In this case, the pressing mechanism 30, 30B may be supported by the upper cover (opposing section) 24 so as to press the electronic component P of the substrate S supported by the lower cover (substrate support section) 23 against the lower cover 23. The pressing mechanisms 30, 30B may be supported by the lower cover (opposing section) 23 so as to press the electronic component P of the substrate S supported by the upper cover (substrate support section) 24 against the upper cover 24. The pressing mechanisms 30, 30B may be supported by the device or the member (opposing section) that is held by the case 20 and becomes a part of the case 20 so as to oppose the floor 210 or the like that supports the substrate S. The substrate S may be supported by a side plate portion of the case 20. The pressing mechanisms 30, 30 B may be supported by a part of the case 20 opposite the side plate portion or by the device or the member supported by the case 20 so as to be opposite the side plate portion.

The pressing member 31 (contacting member 311) of the pressing mechanisms 30, 30B may be formed to contact to the surface of the substrate S instead of the electronic component P. The pressing member 31 may have only one contacting member 311. Depending on heights of the electronic components P and the like in the substrate S, axial lengths of the contacting members 311 in the pressing member 31 may be different from each other. The above openings may be omitted from the substrate S. The electronic components P may be mounted on the front surface or the back surface of the substrate S.

The pressing mechanisms 30, 30B are applied to the ESU 10 for charging the battery 3 by the electric power from the AC power 80 or the external charging device 90. However, the pressing mechanisms 30, 30B may be applied to in-vehicle electrical instruments other than the ESU 10. That is, the pressing mechanism 30, 30B may be applied to substrates of the inverter and/or the boost converter of the PCU 4. The above ESU 10 is mounted on the battery electric vehicle 1 that includes the battery 3 that is charged by the electric power from the AC power source 80 and the external charging device 90. However, the ESU 10 may be mounted on vehicles other than the battery electric vehicle 1. That is, the ESU 10 may be mounted on a non-plug-in hybrid vehicle (HEV) and a plug-in hybrid vehicle (PHEV).

As has been described above, the in-vehicle electrical instrument (10) of the present disclosure is mounted on a vehicle (1) and includes the substrate (S) on which at least one electronic component (P) is mounted and the case (20) configured to accommodate the substrate (S). The in-vehicle electrical instrument (10) further includes: the substrate support section (210) that is naturally or forcibly cooled and disposed in the case (20) to support the substrate (S) ; the opposing section (220, 23) that is disposed in the case (20) to be opposed to the substrate support section (210) at an interval; and a pressing mechanism (30, 30B) that is supported by the opposing section (220, 23) and presses either the electronic component (P) of the substrate (S) supported by the substrate support section (210) or the substrate (S) against the substrate support section (210).

The case of the in-vehicle electrical instrument of the present disclosure includes the substrate support section that is naturally or forcibly cooled and supports the substrate and the opposing section that is opposed to the substrate support section at the interval. The opposing section supports the pressing mechanism. The pressing mechanism presses either the electronic component of the substrate supported by the substrate support section or the substrate against the substrate support section, thereby allowing heat from the electronic component to be released to the substrate support which is naturally or forcibly cooled. Further, since the pressing mechanism is supported by the opposing section in the in-vehicle electrical instrument of the present disclosure, it is not necessary to provide the substrate support section with the structure or the like for pressing the electronic component or the substrate against the substrate support so as to be located around the objective electronic component. This enables the electronic component of the substrate accommodated in the case to be satisfactorily cooled while suppressing the increase in the size of the case, that is, the area of the substrate support section and ensuring the mountability of the in-vehicle electrical instrument.

The pressing mechanism (30, 30B) may include: the pressing member (31) that is disposed between the substrate support section (23, 210, 220) and the opposing section (220, 23) to contact to either the electronic component (P) of the substrate (S) supported by the substrate support section (210) or the substrate (S); and the elastic body (33, 330) that is disposed between the opposing section (220, 23) and the pressing member (31) to bias the pressing member (31) toward the substrate support section (210).

This enables the pressing member biased by the elastic body to press the electronic component or the substrate against the substrate support section, such that the heat from the electronic component is released to the substrate support section that is naturally or forcibly cooled, while reducing the size of the elastic body. In addition, the pressing mechanism allows the heat from the electronic component to be released through the pressing member and the elastic body to the opposing section of the case.

The pressing mechanism (30, 30B) may include the guide member (32) that is supported by the opposing section (220, 23) and slidably supports the pressing member (31) so as to contact to either the electronic component (P) or the substrate (S).

This suppresses the pressing member from falling out of the case during manufacturing or disassembly of the in-vehicle electrical instrument, and also makes the pressing member precisely contact with the corresponding electronic component.

The electronic component (P) may be mounted on the substrate (S) so as to be exposed from the substrate (S) toward both the opposing section (220, 23) and the substrate support section (210).

This allows the electronic component to be in close contact with the substrate support section by the pressing mechanism, thereby enabling satisfactorily cooling of the electronic components.

A plurality of the electronic components (P) may be mounted on the substrate (S). The pressing member (31) may include a plurality of contact members (311) respectively configured to contact to the corresponding electronic component (P) of the substrate (S) supported by the substrate support section (210). The pressing mechanism (30, 30B) may include a support member (312) that supports the contact members (311) at intervals so as to contact to the corresponding electronic component (P). A plurality of the elastic bodies (30, 330) may be disposed between the opposing section (220, 23) and the support member (312).

This enables satisfactorily cooling of the electronic components of the substrate accommodated in the case while suppressing the increase in the size of the case and ensuring the mountability of the in-vehicle electrical instrument.

The elastic bodies (33, 330) may be disposed between the opposing section (220, 23) and the support member (312) so as to be opposed to an end portion of the corresponding contact member (311) on a side of the opposing section (220, 23).

This enables the biasing force from the elastic body to be transmitted stably and efficiently to each contact member.

The elastic body may be a coil spring (33).

This reduces the effect of variations in the distance between the opposing section and the electronic component or the substrate on the load applied from the elastic body to the electronic component or the substrate via the pressing member.

The elastic body may be a leaf spring (330).

This also reduces the effect of variations in the distance between the opposing section and the electronic component or the substrate on the load applied from the elastic body to the electronic component or the substrate via the pressing member.

The substrate support section may be either the bottom (23) of the case (20), the floor (210, 220) of the case (20) above the bottom (23), or the ceiling (24) of the case (20). The opposing section may be either the bottom (23) of the case (20) opposing to the substrate support section (210) in the vertical direction, the floor (210, 220), or the ceiling (24).

The vehicle may be the electric vehicle (1) with the electric motor (MG) that outputs driving force to the wheel (DW) and the battery (3) that supplies electric power to the electric motor (MG). The substrate (s) may be included in the instrument (10) that is used to charge the battery (3) with electric power from the external power source (80, 90).

This enables satisfactorily cooling of the electronic components when charging the battery of the electric vehicle with power from the external power source.

The disclosure is not limited to the above embodiments in any sense but may be changed, altered or modified in various ways within the scope of extension of the disclosure. Additionally, the embodiments described above are only concrete examples of some aspect of the disclosure described in Summary and are not intended to limit the elements of the disclosure described in Summary.

### Industrial Applicability

The technique of the present disclosure is applicable to, for example, the manufacturing industry of the in-vehicle electrical instrument.

## Claims

1. An in-vehicle electrical instrument (10) that is mounted on a vehicle (1) and includes a substrate (S) on which at least one electronic component (P) is mounted and a case (20) configured to accommodate the substrate (S), the in-vehicle electrical instrument (10) comprising:
a substrate support section (210) that is naturally or forcibly cooled and disposed in the case (20) to support the substrate (S);
an opposing section (220, 23) that is disposed in the case (20) to be opposed to the substrate support section (210) at an interval; and
a pressing mechanism (30, 30B) that is supported by the opposing section (220, 23) and presses either the electronic component (P) of the substrate (S) supported by the substrate support section (210) or the substrate (S) against the substrate support section (210).

2. The in-vehicle electrical instrument according to claim 1,
wherein the pressing mechanism (30, 30B) includes: a pressing member (31) that is disposed between the substrate support section (23, 210, 220) and the opposing section (220, 23) to contact to either the electronic component (P) of the substrate (S) supported by the substrate support section (210) or the substrate (s); and an elastic body (33, 330) that is disposed between the opposing section (220, 23) and the pressing member (31) to bias the pressing member (31) toward the substrate support section (210).

3. The in-vehicle electrical instrument according to claim 2,
wherein the pressing mechanism (30, 30B) includes a guide member (32) that is supported by the opposing section (220,23) and slidably supports the pressing member (31) so as to contact to either the electronic component (P) or the substrate (S).

4. The in-vehicle electrical instrument according to any one of claims 1 - 3
wherein the electronic component (P) is mounted on the substrate (S) so as to be exposed from the substrate (S) toward both the opposing section (220, 23) and the substrate support section (210).

5. The in-vehicle electrical instrument according to claim 2, taken in combination with any one of claims 1-5,
wherein a plurality of the electronic components (P) is mounted on the substrate (s),
wherein the pressing member (31) includes a plurality of contact members (311) respectively configured to contact to the corresponding electronic component (P) of the substrate (S) supported by the substrate support section (210),
wherein the pressing mechanism (30, 30B) includes a support member (312) that supports the contact members (311) at intervals so as to contact to the corresponding electronic component (P), and
wherein a plurality of the elastic bodies (30, 330) is disposed between the opposing section (220, 23) and the support member (312).

6. The in-vehicle electrical instrument according to claim 5,
wherein the elastic bodies (33, 330) are disposed between the opposing section (220, 23) and the support member (312) so as to be opposed to an end portion of the corresponding contact member (311) on a side of the opposing section (220, 23).

7. The in-vehicle electrical instrument according to claim 2, taken in combination with any one of claims 1-6,
wherein the elastic body is a coil spring (33).

8. The in-vehicle electrical instrument according to claim 2, taken in combination with any one of claims 1-6,
wherein the elastic body is a leaf spring (330).

9. The in-vehicle electrical instrument according to any one of claims 1 - 8,
wherein the substrate support section (210, 220) is either a bottom (23) of the case (20), a floor (210, 220) of the case (20) above the bottom (23), or a ceiling (24) of the case (20), and
wherein the opposing section is either the bottom (23) of the case (20) opposing to the substrate support section (210) in a vertical direction, the floor (210, 220), or the ceiling (24) .

10. The in-vehicle electrical instrument according to any one of claims 1 - 9,
wherein the vehicle is an electric vehicle (1) with an electric motor (MG) that outputs driving force to a wheel (DW) and a battery (3) that supplies electric power to the electric motor (MG), and
wherein the substrate (S) is included in an instrument (10) that is used to charge the battery (3) with electric power from an external power source (80, 90).
